Europäisches Patentamt

European Patent Office

Office européen des brevets

(11) Veröffentlichungsnummer: **0 022 204**
**B1**

(19)

(12) # EUROPÄISCHE PATENTSCHRIFT

(45) Veröffentlichungstag der Patentschrift:
21.04.82

(21) Anmeldenummer: 80103474.5

(22) Anmeldetag: 21.06.80

(51) Int. Cl.³: **H 01 L 29/72,** H 01 L 29/06,
H 01 L 21/18, H 01 L 21/04

(54) **Bipolarer Transistor und Verfahren zu seiner Herstellung.**

(30) Priorität: 03.07.79 DE 2926785

(43) Veröffentlichungstag der Anmeldung:
14.01.81 Patentblatt 81/2

(45) Bekanntmachung des Hinweises auf die Patenterteilung:
21.04.82 Patentblatt 82/16

(84) Benannte Vertragsstaaten:
AT CH FR GB IT LI NL

(56) Entgegenhaltungen:
DE-A-1 514 727
DE-A-1 916 555
DE-A-2 837 394
SOLID-STATE ELECTRONICS, Band 11, 1968
Oxford S. SCHÄFER »Herstellung von p-n-
Übergängen durch gemeinsame plastische Verformung von p- und n-dotiertem Germanium« Seiten
675 bis 681

(73) Patentinhaber: Licentia Patent-Verwaltungs-GmbH,
Theodor-Stern-Kai 1, D-6000 Frankfurt/Main 70 (DE)

(72) Erfinder: Dahlberg, Reinhard, Dr., Innere Bergstrasse 32,
D-7101 Flein (DE)

(74) Vertreter: Maute, Hans-Jürgen, Dipl.-Ing., Licentia
Patent-Verwaltungs-GmbH Theodor-Stern-Kai 1,
D-6000 Frankfurt/Main 70 (DE)

Bipolarer Transistor und Verfahren zu seiner Herstellung

Die Erfindung beschreibt einen bipolaren Transistor, bei welchem der Basis/Kollektor-Übergang durch geringfügige plastische Verformung des Halbleitergitters erzeugt ist.

Bipolare Transistoren werden heute hauptsächlich in Planarstruktur oder in Mesa-Struktur hergestellt. Als Material hat sich überwiegend Silizium durchgesetzt. Sowohl der Emitter-Basis-Übergang als auch der Basis/Kollektor-Übergang werden zum größten Teil durch Diffusion hergestellt. Weniger häufig werden die Verfahren der Ionenimplantation und der Epitaxie zur Herstellung eines dieser p/n-Übergänge benutzt.

Die Erfindung beschreibt einen Transistor, bei dem der Basis/Kollektor-Übergang durch plastische Verformung hergestellt ist, welcher vor allem für große Leistungen und hohe Frequenzen Kostenvorteile bei der Herstellung aufweist.

Durch die Veröffentlichung (1) ist es bekannt, p/n-Übergänge dadurch zu erzeugen, daß man einen n- und einen p-Halbleiter-Einkristall aus Silizium oder Germanium bei höherer Temperatur unter Druck gemeinsam verformt. Sofern der Verformungsgrad nicht größer als 3% ist (Versetzungsdichte kleiner $10^6/cm^2$) lassen sich nach dieser Methode p/n-Übergänge mit guten elektrischen Eigenschaften erzeugen.

Der bipolare Transistor der Erfindung ist dadurch gekennzeichnet, daß eine p-dotierte und eine n-dotierte einkristalline Halbleiterscheibe vorgesehen sind, daß beide Halbleiterscheiben auf einer Oberflächenseite eine Struktur aus parallel zueinander verlaufenden Wällen aufweisen, daß die eine Halbleiterscheibe die Basiszone mit dem Emitter/Basis-p/n-Übergang enthält, daß die Seitenflächen der Wälle in der Struktur der anderen Halbleiterscheibe eine hochdotierte Oberflächenschicht vom Leitfähigkeitstyp der Basiszone tragen, daß die beiden Halbleiterscheiben unter mechanischem Druck so zusammengesetzt sind, daß die Wälle der strukturierten Oberflächenseiten beider Scheiben sich kreuzen und berühren, und daß die Berührungsflächen infolge plastischer Verformung des Halbleitergitters elektrisch parallel geschaltete, flächengleiche Basis-Kollektor-p/n-Übergänge bilden. Die plastische Verformung des Halbleitergitters an den Berührungsstellen der sich kreuzenden Wälle wird unter Druck und bei erhöhter Temperatur herbeigeführt.

Das Prinzip der gekreuzten parallelen Wälle ist bereits in der Offenlegungsschrift P 2 547 262 beschrieben worden. Die Ausgestaltung dieses Prinzips für bipolare Transistoren wird jedoch in P 2 547 262 nicht erwähnt.

Die Struktur mit den Wällen auf den Halbleiterscheiben kann mit Hilfe eines chemischen, elektrochemischen oder Plasma-Ätz-Verfahrens in an sich bekannter Weise hergestellt werden.

Die Schutzschicht der Maske für das Ätzen der Struktur auf den beiden Halbleiterscheiben kann auch bei einem nachfolgenden Diffusions-, Ionenimplantations- oder Epitax-Prozeß als Maske verwendet werden. Auch für das nachfolgende Aufbringen einer Metallschicht kann die Schutzschicht der Ätzmaske ohne jede Änderung verwendet werden. Mit dem chemischen Auflösen der Schutzsachicht wird auch der auf ihr liegende Teil der Aufdampfschicht fortgeschwemmt.

Die beiden Halbleiterscheiben sind auf ihren nichtstrukturierten Oberflächenseiten mit einem sperrfreien Kontakt versehen.

Die beiden Halbleiterscheiben können auf ihrer strukturierten Seite eine Epitax-Schicht tragen, und die Struktur mit den Wällen kann sich innerhalb dieser Epitaxschicht befinden.

Zur Metallisierung der hochdotierten Schicht mit dem Leitfähigkeitscharakter der Basis auf den Seitenflächen der Wälle werden vorzugsweise Metalle wie W, Mo, Pt, Pd, Cr, Ti, Ni u. a. benutzt.

Als Halbleiter werden vorzugsweise Silizium, Germanium und III/V-Verbindungen benutzt.

Der Transistor der Erfindung eignet sich vorzugsweise für Hochfrequenz-Leistungs-Anwendungen.

Die Erfindung wird im folgenden in 2 Ausführungsbeispielen näher beschrieben.

Das Ausführungsbeispiel 1 zeigt einen pnp-Hochfrequenz-Leistungs-Transistor.

Das Ausführungsbeispiel 2 beschreibt einen npn-Leistungstransistor.

Ausführungsbeispiel 1

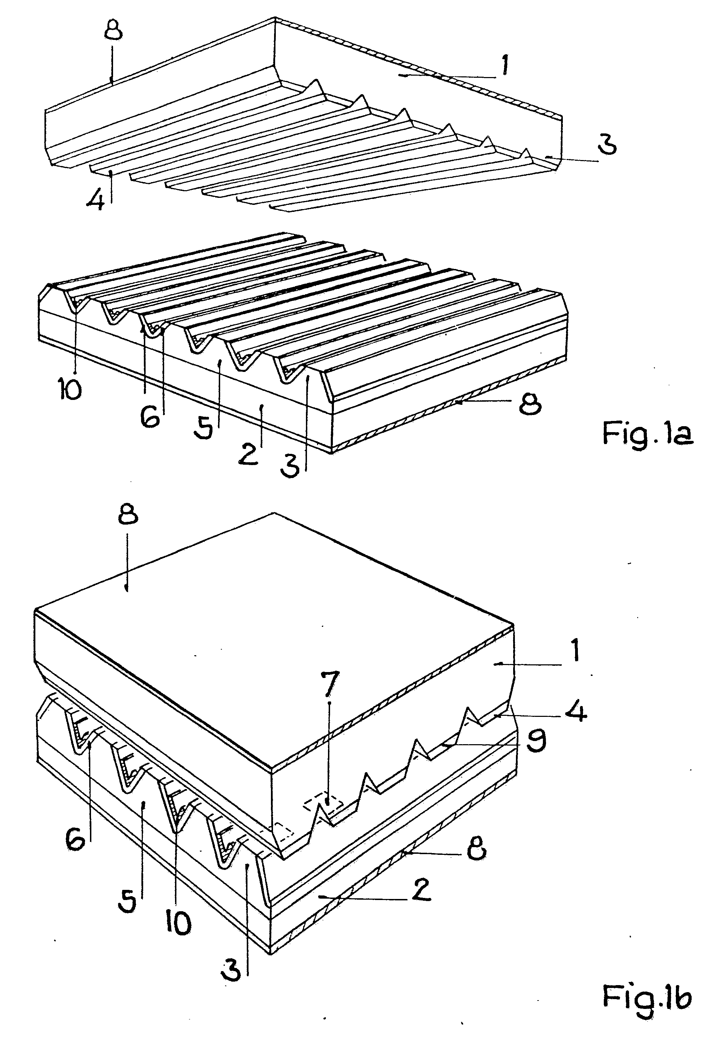

In Fig. 1a sind 1 und 2 (100-orientierte) einkristalline $p^+$-Siliziumscheiben. Die Halbleiterscheibe 1 trägt auf der für die Strukturierung vorgesehenen Oberflächenseite die n-Epitax-Schicht 4, die beim fertigen Bauelement zur Basiszone wird, während die Halbleiterscheibe 2 gleichfalls auf der für die Strukturierung vorgesehenen Oberflächenseite die p-Epitaxschicht 5 aufweist, die beim fertigen Bauelement zur Kollektorzone wird. In beide Halbleiterscheiben 1 und 2 wurde eine Struktur aus parallel zueinander verlaufenden, durch Gräben voneinander getrennten Wällen 3 eingebracht.

In der Halbleiterscheibe 2 befindet sich die Wall-Struktur mit den Wällen 3 innerhalb der Epitax-Schicht 5. In die Seitenflächen der sich auf eine stirnseitige Breite von $2,5 \cdot 10^{-4}$ cm verjüngenden Wälle 3 ist auf der Scheibe 2 eine $n^+$-Schicht 6, was dem Leitfähigkeitstyp der Basiszone 4 entspricht, eingebracht, die jeweils in den zwischen den Wällen liegenden Gräben mit der Metallschicht 10 kontaktiert ist.

Sowohl für die $n^+$-Diffusion der Schicht 6 als auch für die strukturierte Aufbringung der Metallschicht 10 kann die für die Herstellung der Wälle erforderliche Ätzmaske als Maskierung weiterverwendet werden. Diese somit mehrfach nutzbare Maske besteht beispielsweise aus die Stirnflächen der Wälle bedeckenden SiO$_2$-Streifen.

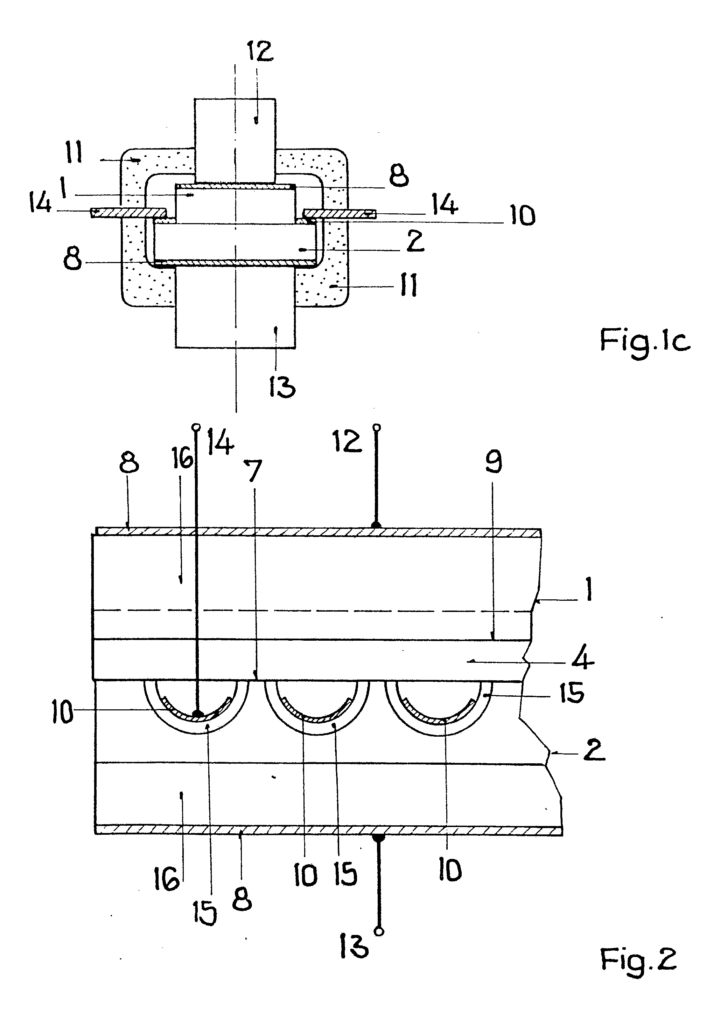

Die beiden Scheiben 1 und 2 werden, wie in Fig. 1b dargestellt, bezüglich der Wallstrukturen um 90° in der Scheibenebene gegeneinander verdreht unter mechanischem Druck so zusammengesetzt, daß die Wälle der beiden Scheiben sich kreuzen und berühren. Über einen Temperaturprozeß in Wasserstoff bei 850°C werden die Berührungsstellen in einkristalline Basis-Kollektor-p/n-Übergänge 7 umgewandelt. Die n$^+$-Schichten 6 werden dabei zu sperrfreien Anschlußkontakten an die Basiszone 4. 8 sind sperrfreie Metallkontakte an den den Wallstrukturen gegenüberliegenden Oberflächenseiten der p$^+$-Scheiben 1 und 2. Die Transistor-Anordnung ist, wie in der Schnittdarstellung der Fig. 1c angedeutet, in ein koaxiales Keramik-Gehäuse 11 eingebracht, bei welchem 12 der Emitter-Anschluß, 13 der Kollektor-Anschluß und 14 der Basis-Anschluß ist. Da der Abstand der Wälle 3 voneinander 1 · 10$^{-3}$ cm beträgt, die Wälle 3 sich bis auf eine Breite von 2,5 · 10$^{-4}$ cm an der Stirnseite verjüngen, die Tiefe der n$^+$-Schicht 6 ca. 5 · 10$^{-5}$ cm beträgt, und die aktive Fläche des Transistors ca. 1 cm$^2$ beträgt, enthält die Transistor-Anordnung ca. 10$^6$ elektrisch parallel geschaltete pnp-Einzelstrukturen mit einer Fläche von je etwa 1,5 × 1,5 · 10$^{-8}$ cm$^2$. Die Anordnung nach F i g. 1 eignet sich besonders als Hochfrequenz-Leistungs-Transistor.

## Ausführungsbeispiel 2

In der Schnittdarstellung der Fig. 2 ist 1 eine n-dotierte einkristalline Siliziumscheibe, in welche einseitig die p$^+$-Diffusionszone 16 eingebracht wurde. Die verbleibende n-leitende Schicht 4 wird die Basiszone der Transistor-Anordnung. 2 ist eine p-leitende einkristalline Silizium-Scheibe, in welche ebenfalls eine p$^+$-Schicht 16 eindiffundiert wurde. Die verbleibende p-Schicht von 2 wird die Kollektorzone der Transistor-Anordnung. In beide Silizium-Scheiben ist auf ihrer hochohmigeren Seite eine Struktur von parallel zueinander verlaufenden Wällen 3 eingebracht worden, welche auf der Halbleiterscheibe 1 durch die Basiszone 4 hindurch in die p$^+$-Zone 16 hineinreicht, während sie auf der Scheibe 2 den p/p$^+$-Übergang nicht durchdringt und nur p-leitendes Material umfaßt. In die Seitenflächen der Wälle 3 auf der Scheibe 2 sind p$^+$-dotierte Schichten 15 eindiffundiert worden, auf welche die metallische Schicht 10 als sperrfreier Kontakt aufgebracht wurde. Die Berührungsflächen der sich überkreuzenden Wälle beider Scheiben sind in Basis/Kollektor-p/n-Übergänge 7 umgewandelt worden. 9 ist der Emitter/Basis-p/n-Übergang in der Scheibe 1. 8 sind sperrfreie Kontakte an den p$^+$-Diffusionszonen 16 an den den Wallstrukturen gegenüberliegenden Oberflächenseiten, an welche der Emitter-Anschluß 12 beziehungsweise der Kollektor-Anschluß 13 angebracht ist. Der Basis-Anschluß 14 ist an der Metallschicht 10 angebracht. Diese Transistor-Anordnung eignet sich mit Abständen der Wälle 3 von größenordnungsmäßig 10$^{-2}$ cm und Basis/Kollektor-p/n-Flächen von kleiner als 10$^{-6}$ cm$^2$ für npn- und pnp-Leistungs-Transistoren für allgemeine Anwendungen in der Elektronik. Sie kann so ausgebildet werden, daß sie für die Verarbeitung von kleinen bis zu allergrößten Verlust-Leistungen geeignet ist.

## Literatur

(1) S. Schäfer »Herstellung von p-n-Übergängen durch gemeinsame plastische Verformung von p- und n-dotiertem Germanium« Solid-State-Electronics, 11, 675 — 681 (1968)

## Bezugsziffern

1 Halbleiterscheibe 1
2 Halbleiterscheibe 2
3 Wälle
4 Basis-Zone
5 p-dotierte Epitax-Schicht
6 dünne n$^+$-dotierte Schicht
7 Basis/Kollektor-Übergang
8 sperrfreier Kontakt
9 Emitter/Basis-Übergang
10 metallische Schicht
11 koaxiales Gehäuse
12 Emitter-Anschluß
13 Kollektor-Anschluß
14 Basis-Anschluß
15 p$^+$-dotierte Schicht
16 dicke p$^+$-Diffusions-Schichten

## Patentansprüche

1. Bipolarer Transistor mit einem durch plastische Verformung erzeugten p/n-Übergang, dadurch gekennzeichnet, daß eine p-dotierte und eine n-dotierte einkristalline Halbleiterscheibe (1 und 2) vorgesehen sind, daß beide Halbleiterscheiben (1, 2) auf einer Oberflächenseite eine Struktur aus parallel zueinander verlaufenden Wällen (3) ausweisen, daß die eine Halbleiterscheibe (1) die Basis-Zone (4) mit dem Emitter-Basis-p/n-Übergang (5) enthält, daß die Seitenflächen der Wälle (3) in der Struktur der anderen Halbleiterscheibe (2) eine hochdotierte Oberflächenschicht (6) vom Leitfähigkeitstyp der Basiszone (4) tragen, daß die beiden Halbleiterscheiben (1, 2) unter mechanischem Druck so zusammengesetzt sind, daß die Wälle (3) der strukturierten Oberflächenseiten beider Scheiben sich kreuzen und berühren, und daß die Berührungsflächen infolge plastischer Verformung des Halbleitergitters elektrisch parallel geschaltete, flächengleiche Basis-Kollektor-p/n-Übergänge (7) bilden.

2. Bipolarer Transistor nach Anspruch 1, dadurch gekennzeichnet, daß die Wälle sich zur freiliegenden Stirnfläche hin verjüngen.

3. Bipolarer Transistor nach einem der vorhergehenden Ansprüche, dadurch gekennzeichnet, daß die beiden Halbleiterscheiben (1, 2) je einen sperrfreien Kontakt (8) haben.

4. Bipolarer Transistor nach einem der vorhergehenden Ansprüche, dadurch gekennzeichnet, daß die beiden Halbleiterscheiben (1, 2) einseitig Epitax-Schichten tragen, und daß sich die Struktur mit den Wällen (3) zumindest auf einer Halbleiterscheibe innerhalb dieser Epitax-Schicht befindet.

5. Bipolarer Transistor nach einem der vorhergehenden Ansprüche, dadurch gekennzeichnet, daß zur Metallisierung (10) der hochdotierten Oberflächenschicht (6) auf den Seitenflächen der Wälle (3) vorzugsweise Metalle wie Wolfram, Tantal, Molybdän, Platin, Palladium, Chrom und Titan vorgesehen sind.

6. Bipolarer Transistor nach einem der vorhergehenden Ansprüche, dadurch gekennzeichnet, daß als Halbleitermaterial Silizium, Germanium oder III/V-Verbindungen vorgesehen ist.

7. Bipolarer Transistor nach einem der vorhergehenden Ansprüche, dadurch gekennzeichnet, daß er für Hochfrequenz-Anwendungen vorgesehen ist.

8. Verfahren zum Herstellen eines bipolaren Transistors nach einem der vorangehenden Ansprüche, dadurch gekennzeichnet, daß die Basis-Kollektor-p/n-Übergänge durch plastische Verformung des Halbleitergitters infolge eines auf die Scheiben einwirkenden mechanischen Drucks bei erhöhter Temperatur erzeugt werden.

9. Verfahren nach Anspruch 8, dadurch gekennzeichnet, daß die Wallstrukturen auf den Halbleiterscheiben (1, 2) mit Hilfe eines chemischen oder Plasma-Ätzverfahrens hergestellt werden.

10. Verfahren nach Anspruch 8 oder 9, dadurch gekennzeichnet, daß die Maske für das Ätzen der Wall-Strukturen auch als Diffusions-, Ionenimplantations- oder Epitax-Maske beim nachfolgenden Einbringen der hochdotierten Schicht in die Seitenflächen der Wälle (3) verwendet wird.

11. Verfahren nach einem der vorhergehenden Ansprüche 8 bis 10, dadurch gekennzeichnet, daß die Maske für das Ätzen der Wall-Strukturen auch als Maske für das Aufbringen einer Metall-Kontaktschicht an die hochdotierte Oberflächenschicht (6) verwendet wird.

**Claims**

1. A bipolar transistor having a p/n junction produced by means of plastic deformation, characterised in that a p-doped and an n-doped monocrystalline semiconductor lamella (1 and 2) are provided; that both semiconductor lamellae (1, 2) have a structure comprising parallel ridges (3) on one face; that one semiconductor lamella (1) contains the base region (4) with the emitter-base p/n junction (5); that the side surfaces of the ridges (3) in the structure of the other semiconductor disc (2) have a highly doped surface layer (6) with the type of conductivity of the base region (4); that the two semiconductor lamellae (1, 2) are joined by mechanical pressure so that the ridges (3) of the structured faces of both lamellae cross and touch; and that the surfaces in contact form electrically parallel base-collector p/n junctions (7) of equal area as the result of plastic deformation of the semiconductor lattice.

2. A bipolar transistor according to claim 1, characterised in that the ridges taper towards the outer surface.

3. A bipolar transistor according to any one of the preceding claims, characterised in that each of the two semiconductor lamellae (1, 2) has an ohmic contact (8).

4. A bipolar transistor according to any one of the preceding claims, characterised in that the two semiconductor lamellae (1, 2) have epitaxial layers on one side and that the structure having the ridges (3) is located at least on one semiconductor lamella within this epitaxial layer.

5. A bipolar transistor according to any one of the preceding claims, characterised in that metals, preferably such as tungsten, tantalum, molybdenum, platinum, palladium, chromium and titanium, are provided as metallisation (10) for the highly-doped surface layer (6) on the side surfaces of the ridges (3).

6. A bipolar transistor according to any one of the preceding claims, characterised in that silicon, germanium or III/V-compounds are provided as the semiconductor material.

7. A bipolar transistor according to any one of the preceding claims, characterised in that it is provided for high frequency applications.

8. A method of manufacturing a bipolar transistor according to any one of the preceding claims, characterised in that the base-collector p/n junctions are produced by plastic deformation of the semiconductor lattice as a result of a mechanical pressure acting on the lamellae at an elevated temperature.

9. A method according to claim 8, characterised in that the ridge structure on the semiconductor lamellae (1, 2) are manufactured with the aid of a chemical or plasma etching technique.

10. A method according to claim 8 or 9, characterised in that the mask for etching the ridge structures is also used as a diffusion, ion implantation, or epitaxial mask during subsequent insertion of the highly doped layer into the side surfaces of the ridges (3).

11. A method according to any one of the preceding claim 8 to 10, characterised in that the mask for etching the ridge structures is also used as a mask for applying a metal/contact layer to the highly doped surface layer (6).

## Revendications

1. Transistor bipolaire comportant une jonction p-n produite par déformation plastique et caractérisé en ce qu'une pastille semiconductrice monocristalline n (1) et une pastille semiconductrice monocristalline p (2) sont prévues; les deux pastilles semiconductrices (1, 2) présentent sur une face une structure de proéminences (3) parallèles; la pastille semiconductrice (1) contient la région de base (4) avec la jonction p-n émetteur-base (5); les faces latérales des proéminences (3) de la structure de la seconde pastille semiconductrice (2) portent une couche superficielle (6) fortement dopée et du même type que la région de base (4); les deux pastilles semiconductrices (1, 2) sont assemblées sous pression mécanique, de façon que les proéminences (3) des faces structurées des deux pastilles se croisent et viennent en contact; et par suite d'une déformation plastique du réseau semicristallin, les surfaces de contact forment des jonctions p-n base-collecteur (7) de même surface et couplées électriquement en parallèle.

2. Transistor bipolaire selon revendication 1, caractérisé en ce que les proéminences se rétrécissent vers la face frontale libre.

3. Transistor bipolaire selon une des revendications 1 et 2, caractérisé en ce que les deux pastilles semiconductrices (1, 2) portent chacune un contact (8) sans tension inverse.

4. Transistor bipolaire selon une quelconque des revendications 1 à 3, caractérisé en ce que les deux pastilles semiconductrices (1, 2) portent sur une face une couche épitaxiée; et la structure de proéminences (3) se trouve dans ladite couche épitaxiée sur une pastille semiconductrice au moins.

5. Transistor bipolaire selon une quelconque des revendications 1 à 4, caractérisé en ce que des métaux tels que tungstène, tantale, molybdène, platine, palladium, chrome et titane, sont utilisés de préférence pour la métallisation (10) de la couche superficielle (6) fortement dopée sur les faces latérales des proéminences (3).

6. Transistor bipolaire selon une quelconque des revendications 1 à 5, caractérisé par l'emploi de silicium, de germanium ou de composés III-V comme matériau semiconducteur.

7. Transistor bipolaire selon une quelconque des revendications 1 à 6, caractérisé par son emploi dans des applications haute fréquence.

8. Procédé de production d'un transistor bipolaire selon une quelconque des revendications 1 à 7, caractérisé en ce que les jonctions p-n base-collecteur sont produites par déformation plastique du réseau semiconducteur par une pression mécanique s'exerçant à haute température sur les pastilles.

9. Procédé selon revendication 8, caractérisé en ce que les structures de proéminences sont produites sur les pastilles semiconductrices (1, 2) par un procédé de gravure chimique ou au plasma.

10. Procédé selon une des revendications 8 et 9, caractérisé en ce que le masque de gravure des structures de proéminences est également utilisé comme masque de diffusion, d'implantation d'ions ou d'épitaxie pour l'introduction ultérieure de la couche fortement dopée dans les faces latérales des proéminences (3).

11. Procédé selon une quelconque des revendications 8 à 10, caractérisé en ce que le masque de gravure des structures de proéminences est également utilisé comme masque pour le dépôt d'une couche de contact métallique sur la couche superficielle fortement dopée (6).

Fig.1a

Fig.1b

Fig.1c

Fig.2

9